# EUROPEAN PATENT APPLICATION

(11) **EP 4 836 646 A1**
(43) Date of publication of application: **04.11.2026**
(21) Application number: 25203261.0
(22) Date of filing: 19.09.2025
(51) Int. Cl.: H10H 29/80, H10H 29/851

(54) **PLANAR LIGHTING DEVICE AND DISPLAY DEVICE USING SAME**

(30) Priority: 29.04.2025 KR 20250055963
(71) Applicant: LG Electronics Inc., Yeongdeungpo-gu Seoul 07336 (KR)
(72) Inventor: KIM, Jaehyeok, Seoul (KR); LEE, Jeoungoun, Seoul (KR); JEONG, Sehoon, Seoul (KR)
(74) Representative: Vossius & Partner Patentanwälte Rechtsanwälte mbB

(57) **Abstract**

The present disclosure is applicable to a technical field related to display devices, and relates to, for example, a planar lighting device and a display device using a light-emitting device package. In an aspect of the present disclosure, a planar lighting device may include a wiring board; a light source including a plurality of first light-emitting device packages and a plurality of second light-emitting device packages disposed on the wiring board; and a light diffusion layer disposed on the light source.

## Description

### BACKGROUND

### 1. Technical Field

The present disclosure is applicable to a technical field related to display devices, and relates to, for example, a planar lighting device and a display device using a light-emitting device package.

### 2. Description of Related Art

Recently, display devices having excellent characteristics such as thinness, flexibility, etc., are being developed in the fields of display technologies. The major displays currently commercialized are represented by liquid crystal displays (LCDs) and organic light emitting diodes (OLEDs).

**In** the displays, the liquid crystal display devices (LCDs) are used in a variety of devices including televisions, laptop computers, desktop computer monitors, and mobile phones.

Since the LCDs do not emit light by themselves, a light emitting device that is capable of illuminating a liquid crystal panel is required to display image information.

Since the light emitting device of the LCD is connected to a rear surface of the liquid crystal panel, the light emitting device may be called a planar lighting device or a backlight unit. The backlight unit may be called a device that forms a uniform surface light source to provide a light source to the liquid crystal panel.

The backlight unit as described above may be considered an example of the planar lighting device because the backlight unit provides a planar light source toward the liquid crystal panel. The planar lighting device is recognized as a light source that is capable of evenly irradiating light through a flat surface and have a relatively thin thickness.

The light emitting device such as the light emitting diode is used as the light source for the planar lighting device. To implement a white light source in the light emitting device, a blue light emitting device and a phosphor may be used in combination. For example, the blue light emitting device and a yellow phosphor may be combined to implement the white light source.

### SUMMARY

The technical problem to be solved by the present disclosure is to provide a planar lighting device and display device capable of improving color reproducibility.

The technical problem to be solved by the present disclosure is to provide a planar lighting device and display device capable of improving light efficiency while implementing high color reproducibility.

The technical problem to be solved by the present disclosure is to provide a planar lighting device and display device capable of implementing a consistent color reproducibility in panels having different characteristics.

**In** an aspect of the present disclosure, a planar lighting device may include a wiring board; a light source including a plurality of first light-emitting device packages and a plurality of second light-emitting device packages disposed on the wiring board; and a light diffusion layer disposed on the light source, wherein the first light-emitting device package includes: a first light-emitting device including a first light-emitting layer having a first light-emitting wavelength band that emits light of a first color and a second light-emitting layer having a second light-emitting wavelength band that emits light of a second color; and a first phosphor having a third light-emitting wavelength band converted by light emitted from the first light-emitting device to emit light of a third color, and wherein the second light-emitting device package includes: a second light-emitting device including a third light-emitting layer having a fourth light-emitting wavelength band that emits light of the first color; a second phosphor having a fifth light-emitting wavelength band converted by light emitted from the second light-emitting device to emit light of the second color; and a third phosphor having a sixth light-emitting wavelength band converted by light emitted from the second light-emitting device to emit light of the third color.

In an exemplary embodiment, a half-width of the spectrum of the first light-emitting wavelength band may be narrower than a half-width of the spectrum of the fourth light-emitting wavelength band.

**In** an exemplary embodiment, an intensity of the spectrum of the first light-emitting wavelength band may be smaller than an intensity of the spectrum of the fourth light-emitting wavelength band.

**In** an exemplary embodiment, a half-width of the spectrum of the fifth light-emitting wavelength band may be narrower than a half-width of the spectrum of the second light-emitting wavelength band.

**In** an exemplary embodiment, an intensity of the spectrum of the fifth light-emitting wavelength band may be smaller than an intensity of the spectrum of the second light-emitting wavelength band.

**In** an exemplary embodiment, the first light-emitting device package and the second light-emitting device package may have different color coordinate settings.

**In** an exemplary embodiment, the first light-emitting device package and the second light-emitting device package may be disposed adjacent to each other.

**In** an exemplary embodiment, a shift in a color coordinate of the second light-emitting device package according to current may be smaller than a shift in a color coordinate of the first light-emitting device package according to current.

**In** an exemplary embodiment, the first light-emitting device package may include a first-1 light-emitting device and a first-2 light-emitting device that are adjacent to each other.

In an exemplary embodiment, the first-1 light-emitting device and the first-2 light-emitting device may have different stacking orders of the first light-emitting layer and the second light-emitting layer.

In another aspect of the present disclosure, a display device may include a planar lighting device emitting white light; and a liquid crystal display panel disposed on the planar lighting device and having a color conversion filter for converting the white light of the planar lighting device, the planar lighting device comprising: a light source including a plurality of first light-emitting device packages and a plurality of second light-emitting device packages constituting a white light source; and a light diffusion layer disposed on the light source, wherein the first light-emitting device package includes: a first light-emitting device including a first light-emitting layer having a first light-emitting wavelength band that emits light of a first color and a second light-emitting layer having a second light-emitting wavelength band that emits light of a second color; and a first phosphor having a third light-emitting wavelength band converted by light emitted from the first light-emitting device to emit light of a third color, and wherein the second light-emitting device package includes: a second light-emitting device including a third light-emitting layer having a fourth light-emitting wavelength band that emits light of the first color; a second phosphor having a fifth light-emitting wavelength band converted by light emitted from the second light-emitting device to emit light of the second color; and a third phosphor having a sixth light-emitting wavelength band converted by light emitted from the second light-emitting device to emit light of the third color.

In an exemplary embodiment, a content of at least one of the second phosphor or the third phosphor of the second light-emitting device package may be adjusted according to a transmission spectrum of the color conversion filter.

In an exemplary embodiment, the second phosphor may have a first content so as to have a target color coordinate value of the liquid crystal display panel.

In an exemplary embodiment, the third phosphor may have a second content so as to have a target color coordinate value of the liquid crystal display panel.

In still another aspect of the present disclosure, a display device may include a planar lighting device emitting white light; and a liquid crystal display panel disposed on the planar lighting device and having a color conversion filter for converting the white light of the planar lighting device, wherein the planar lighting device includes: a light source including a plurality of light-emitting device packages constituting a white light source; and a light diffusion layer disposed on the light source, wherein the light-emitting device packages includes: a light-emitting device including a first light-emitting layer having a first light-emitting wavelength band that emits light of a first color and a second light-emitting layer having a second light-emitting wavelength band that emits light of a second color; and a phosphor having a third light-emitting wavelength band converted by light emitted from the light-emitting device and emits light of a third color.

### BRIEF DESCRIPTION OF THE DRAWINGS

FIG. 1 is a conceptual diagram of a planar lighting device according to a first embodiment of the present disclosure.
FIG. 2 is a cross-sectional schematic diagram illustrating an example of a first light-emitting device package applied to a planar lighting device according to a first embodiment of the present disclosure.
FIG. 3 is a cross-sectional schematic diagram illustrating another example of a light-emitting device package applied to a planar lighting device according to a first embodiment of the present disclosure.
FIG. 4 is a cross-sectional schematic diagram illustrating a first light-emitting device applied to a planar lighting device according to a first embodiment of the present disclosure.
FIG. 5 is a cross-sectional schematic diagram illustrating an example of a second light-emitting device package applied to a planar lighting device according to a first embodiment of the present disclosure.
FIG. 6 is a cross-sectional schematic diagram showing an example of a second light-emitting device applied to a planar lighting device according to a first embodiment of the present disclosure.
FIG. 7 is a cross-sectional schematic diagram showing another example of a second light-emitting device applied to a planar lighting device according to a first embodiment of the present disclosure.
FIG. 8 is a diagram showing the emission spectrum of a first light-emitting device package applied to a planar lighting device according to a first embodiment of the present disclosure.
FIG. 9 is a diagram showing the emission spectrum of a second light-emitting device package applied to a planar lighting device according to a first embodiment of the present disclosure.
FIG. 10 is a conceptual diagram of a planar lighting device according to a second embodiment of the present disclosure.
FIG. 11 is a conceptual diagram of a planar lighting device according to a third embodiment of the present disclosure.
FIG. 12 is a schematic diagram illustrating a process of tuning a target color coordinate of the display device using the planar lighting device according to the second or third embodiment of the present disclosure.
FIG. 13 is a schematic diagram illustrating a process of tuning a target color coordinate of the display device using the planar lighting device according to the first embodiment of the present disclosure.
FIGS. 14 to 19 are cross-sectional schematic diagrams illustrating another embodiments of the first light-emitting device package applied to the planar lighting device according to the embodiments of the present disclosure.
FIGS. 20 and 21 are diagrams for describing differences according to the stacking order of the first light-emitting device package applied to the planar lighting device according to embodiments of the present disclosure.
FIG. 22 is a diagram illustrating a wavelength change according to a driving current of the first light-emitting device package applied to the planar lighting device according to embodiments of the present disclosure.
FIG. 23 is a diagram illustrating the emission spectrum of the display device according to the embodiments of the present disclosure.
FIGS. 24 and 25 are diagrams illustrating a display device according to a first embodiment of the present disclosure.
FIGS. 26 and 27 are diagrams illustrating a display device according to a second embodiment of the present disclosure.

### DETAILED DESCRIPTION OF THE EMBODIMENTS

Hereinafter, embodiments disclosed in this specification is described with reference to the accompanying drawings, and the same or corresponding components are given with the same drawing number regardless of reference number, and their duplicated description will be omitted. The suffixes "module" and "part" for components used in the description below are assigned or mixed in consideration of easiness in writing the specification and do not have distinctive meanings or roles by themselves. In addition, in describing embodiments disclosed in this specification, if it is determined that detailed descriptions of related known technologies obscure the gist of the embodiments disclosed in this specification, the detailed descriptions will be omitted. In addition, it should be noted that the attached drawings are only intended to facilitate easy understanding of the embodiments disclosed in this specification, and should not be construed as limiting the technical ideas disclosed in this specification by the attached drawings.

Furthermore, although each drawing is described for convenience of explanation, it is also within the scope of the present disclosure for those skilled in the art to implement another embodiment by combining at least two or more drawings.

In addition, in the following description, it will be understood that when an device such as a layer, a region, or substrate is referred to as being "on" another layer, region, or substrate, it can be directly on the other layer, region, or substrate, or intervening layers, regions, or substrates may also be present.

A display device described in this specification is a concept that includes all display devices that display information as a unit pixel or a set of unit pixels. Therefore, it may be applied not only to finished products but also to parts. For example, a panel, which is a component of a digital TV, is also considered the display device under this specification. The finished products may include mobile phones, smart phones, laptop computers, digital broadcasting terminals, personal digital assistants (PDAs), portable multimedia players (PMPs), navigation systems, slate PCs, tablet PCs, ultra books, digital TVs, and desktop computers.

However, those skilled in the art will readily recognize that the configuration according to the embodiments described herein may be applied to devices capable of displaying, even if they are new product types developed in the future.

In addition, the semiconductor light emitting device mentioned in the specification is a concept that includes LEDs, mini-LEDs, micro-LEDs, and the like, and may be used interchangeably.

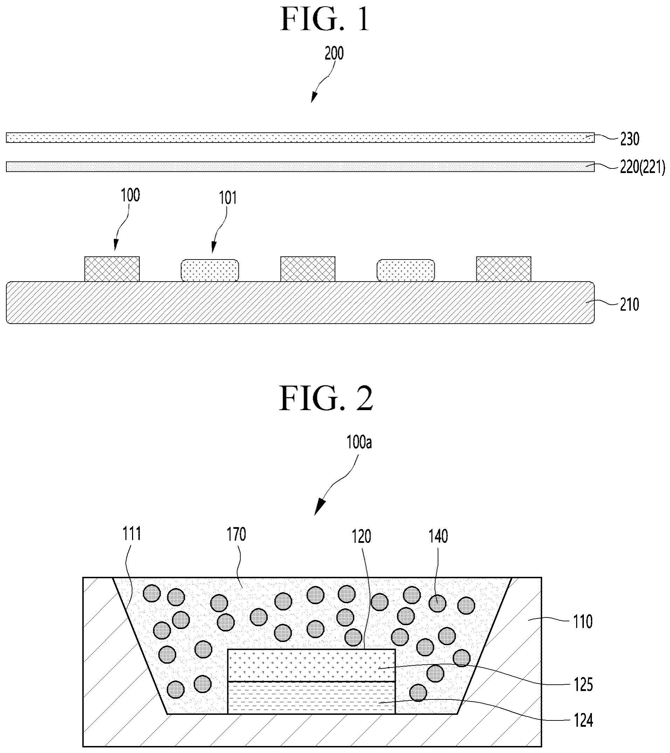

FIG. 1 is a conceptual diagram of a planar lighting device according to a first embodiment of the present disclosure.

Referring to FIG. 1, a planar lighting device 200 according to a first embodiment of the present disclosure will be described.

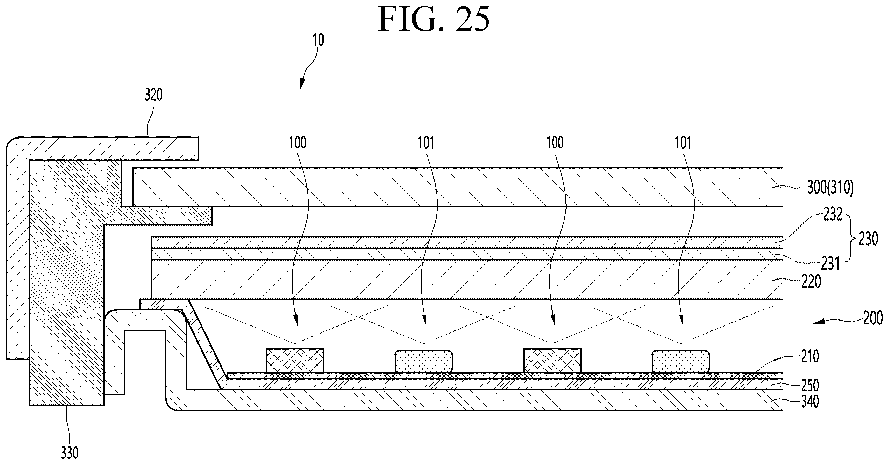

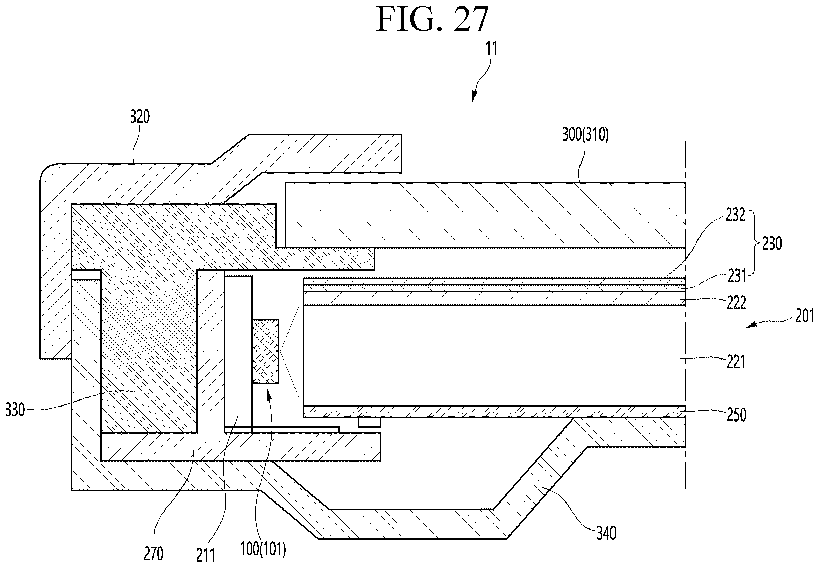

Here, the planar lighting device 200 may be used as a backlight unit or may be the same device as a backlight unit. The backlight unit provides a flat light source toward the liquid crystal panel 300 and 301 (see FIGS. 25 and 27), and thus may be considered an example of a planar lighting device. Such a planar lighting device may refer to a light source that may uniformly irradiate light through a flat surface and has a relatively thin thickness. Hereinafter, the planar lighting device 200 and the backlight unit 200 will be described interchangeably using the same reference numeral.

The planar lighting device 200 according to the first embodiment may include a wiring board 210, a light source including a plurality of first light-emitting device packages 100 and a plurality of second light-emitting device packages 101 arranged and positioned on the wiring board 210, and a light diffusion layer 220 (221) positioned on the light source.

Here, the light diffusion layer 220 (221) may be implemented as a light diffusion plate 220 or a light guide plate 221 depending on the shape of the backlight unit 200.

As an exemplary embodiment, an optical sheet 230 may be positioned on one side of the light diffusion layer 220 (221). For example, a light diffusion layer 220 (221) may be positioned between the wiring board 210 and the optical sheet 230. For example, the optical sheet 230 may include a plurality of layers having optical functions.

The first light-emitting device package 100 and the second light-emitting device package 101 may be arranged and provided on the wiring board 210. The plurality of light-emitting device packages 100 and 101 may emit white light. The plurality of light-emitting device packages 100 and 101 may be positioned at a regular interval on the wiring board 210.

Although not separately illustrated, the wiring board 210 may include a connection wiring electrically connected to the plurality of first light-emitting device packages 100 and the plurality of second light-emitting device packages 101. For example, at least some of the plurality of first light-emitting device packages 100 and the plurality of second light-emitting device packages 101 may be individually driven by connecting such connection wires. For example, the light sources may be driven simultaneously, or may be driven differently by dividing them into regions. In this way, a form in which the light sources are driven differently by dividing them into regions may be referred to as local dimming driving. A detailed description thereof is omitted here.

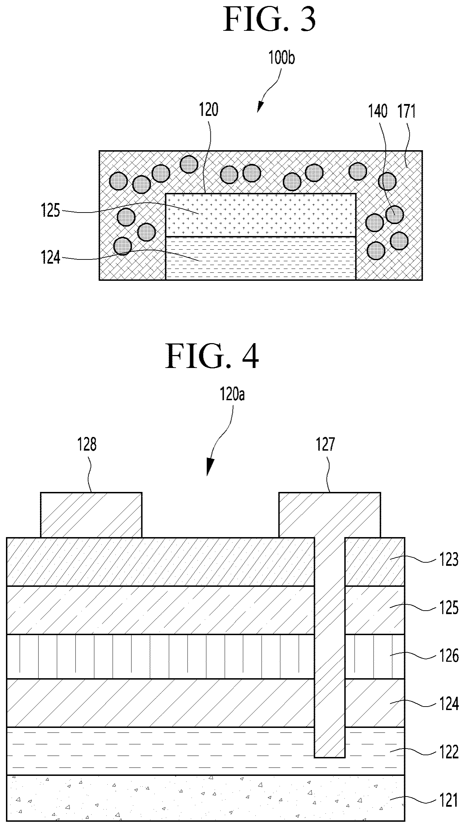

Here, the first light-emitting device package 100 may include a stacked light-emitting device 120 (a first light-emitting device; see FIG. 2) having two light-emitting layers 124 and 125 (see FIG. 4). The first light-emitting device package 100 may emit white light having a first color coordinate by including the first light-emitting device 120 and a phosphor 140 (a first phosphor; see FIG. 2) excited by light emitted from the first light-emitting device 120. This will be described in detail below.

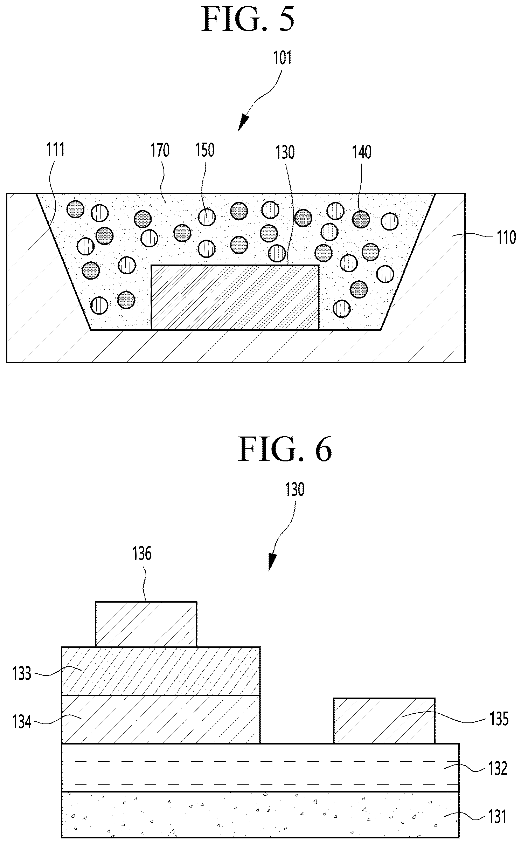

The second light-emitting device package 101 may include a light-emitting device 130 (second light-emitting device; see FIG. 5) that emits light of one color (first color). The second light-emitting device package 101 may include a phosphor 150 (second phosphor; see FIG. 5) that is excited by light emitted from the second light-emitting device 130 to emit light of a second color, and the phosphor 140 (third phosphor; see FIG. 5) that is excited by light emitted from the second light-emitting device 130 to emit light of a third color, thereby emitting white light having a second color coordinate. This will be described in detail below.

In this way, the planar lighting device 200 may include the first light-emitting device package 100 and the second light-emitting device package 101 that have different color coordinate settings.

For example, the color reproducibility of the planar lighting device 200 may be improved using the first light-emitting device package 100. The brightness of the planar lighting device 200 may be improved or the color coordinates may be adjusted using the second light-emitting device package 101. For example, the first light-emitting device package 100 may have high color reproducibility but the color coordinates may be fixed, and the second light-emitting device package 101 may have high brightness or the color coordinates may be changed.

The first light-emitting device package 100 may be configured to improve the color reproducibility of the planar lighting device 200. Meanwhile, the second light-emitting device package 101 may be configured to improve the brightness of the planar lighting device 200. In addition, the second light-emitting device package 101 may be configured to change the color coordinates of the planar lighting device 200 according to a target color coordinate.

The color coordinate of white light emitted from the planar lighting device 200 may be adjusted according to a target color coordinate by using the first light-emitting device package 100 and the second light-emitting device package 101 having such different color coordinate settings. Meanwhile, the planar lighting device 200 may be implemented to be used in a display device 10 (see FIGS. 25 and 27) so that the display device 10 may express a target color coordinate. This will be described in detail below.

FIG. 2 is a cross-sectional schematic diagram illustrating an example of a first light-emitting device package applied to a planar lighting device according to a first embodiment of the present disclosure. FIG. 3 is a cross-sectional schematic diagram illustrating another example of a light-emitting device package applied to a planar lighting device according to a first embodiment of the present disclosure. FIG. 4 is a cross-sectional schematic diagram illustrating a first light-emitting device applied to a planar lighting device according to a first embodiment of the present disclosure.

The first light-emitting device package 100 may include the first light-emitting device 120 includes a first light-emitting layer 124 that emits light of a first color and has a first light-emitting wavelength band, and a second light-emitting layer 125 that emits light of a second color and has a second light-emitting wavelength band, which are stacked, and the first phosphor 140 that is converted by light emitted from the first light-emitting device 120 to emit light of a third color and has a third light-emitting wavelength band.

Here, as an example, the first color may be blue light and the second color may be green light. Additionally, the third color may be red light. In other words, the first light-emitting wavelength band may be a wavelength band corresponding to blue light. The second light-emitting wavelength band may be a wavelength band corresponding to green light. The third wavelength band may be a wavelength band corresponding to red light.

Here, the positions of the first light-emitting layer 124 and the second light-emitting layer 125 may be interchanged. While FIGS. 2 to 4 illustrate an example in which the second light-emitting layer 125 is positioned over the first light-emitting layer 124, conversely, the first light-emitting layer 124 may be positioned over the second light-emitting layer 125.

In FIG. 4, the first light-emitting layer 124 and the second light-emitting layer 125 represent active layers of a light-emitting device 120 having a multiple quantum well (MQL) structure. However, in FIGS. 2 and 3, they may each refer to a light-emitting unit having a multilayer structure that emits the first color and the second color.

Referring to FIGS. 2 and 4 together, for example, the first light-emitting device package 100 may be configured in the form of the first light-emitting device package 100a as illustrated in FIG. 2.

The first light-emitting device package 100a may be configured to include a package body 110 including a reflective cup 111 shape, a first light-emitting device 120 disposed within the package body 110, a first molding layer 170 covering the first light-emitting device 120 and disposed within the reflective cup shape 111, and the first phosphor 140 disposed within the first molding layer 170.

Here, the first molding layer 170 may be formed using a resin material such as epoxy, silicone, or the like. The first phosphor 140 may be provided in a powder form and dispersed within the first molding layer 170.

Although not illustrated, the package body 110 may include circuit lines, and the first light-emitting device 120 may be mounted within the package body 110 and electrically connected to the circuit lines. The package body 110 may include a pad that may be electrically connected to the outside. A detailed description of this configuration is omitted.

Referring to FIGS. 3 and 4 together, as an example, the first light-emitting device package 100 may be configured in the form of a first light-emitting device package 100b as in FIG. 3.

FIG. 3 shows an example of the light-emitting device package 100b in the form of a chip scale package (CSP) in which a second molding layer 171 in which the first phosphor 140 is dispersed is coated on the light-emitting device 120 to form a package.

The first light-emitting device package 100b includes the second molding layer 171 coated on the outside of the first light-emitting device 120 and the first phosphor 140 dispersed within the second molding layer 171. The light emitting device 120a may be configured to include the first phosphor 140.

Referring to FIG. 3, the second molding layer 171 having a predetermined thickness may be positioned on the outer surface of the light emitting device 130 excluding the lower surface.

Referring to FIG. 4, a cross-section of a first light emitting device 120a according to an embodiment is schematically illustrated.

The first light emitting device 120a may sequentially include a first conductive type for example, N-type semiconductor layer 122, a first light emitting layer 124, a barrier layer 126, a second light emitting layer 125, and a second conductive type for example, P-type semiconductor layer 123 on a substrate 121.

Here, the first conductive semiconductor layer 122 may include, for example, an N-type nitride semiconductor (N-GaN) layer. The second conductive semiconductor layer 123 may include, for example, a P-type nitride semiconductor (P-GaN) layer.

The barrier layer 126 may also include a nitride semiconductor as a conductive semiconductor layer. The barrier layer 126 may include an N-type or P-type conductive semiconductor layer, or may include both N-type and P-type semiconductor layers.

A first electrode 127 electrically connected to the first conductive semiconductor layer 122 may be positioned on one side of the second conductive semiconductor layer 123. In this case, the first electrode 127 and the second conductive semiconductor layer 123 are insulated from each other, and the first electrode 127 may be connected to the first conductive semiconductor layer 122 by a structure such as a through hole.

A second electrode 128 electrically connected to the second conductive semiconductor layer 123 may be positioned on the other side of the second conductive semiconductor layer 123.

As mentioned above, the positions of the first light-emitting layer 124 and the second light-emitting layer 125 may be interchanged.

In this way, the first light-emitting device 120a may emit both first color light and second color light.

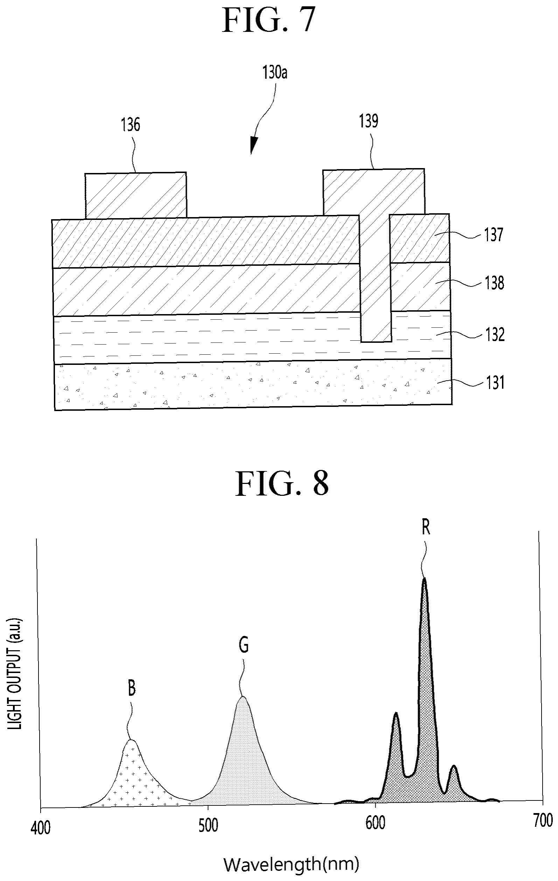

FIG. 5 is a cross-sectional schematic diagram illustrating an example of a second light-emitting device package applied to a planar lighting device according to a first embodiment of the present disclosure. FIG. 6 is a cross-sectional schematic diagram showing an example of a second light-emitting device applied to a planar lighting device according to a first embodiment of the present disclosure. FIG. 7 is a cross-sectional schematic diagram showing another example of a second light-emitting device applied to a planar lighting device according to a first embodiment of the present disclosure.

The second light-emitting device package 101 may include a second light-emitting device 130 and 130a including a third light-emitting layer 134 and 138 having a fourth light-emitting wavelength band that emits light of the first color, a second phosphor 150 having a fifth light-emitting wavelength band that is converted by light emitted from the second light-emitting device 130 and 130a to emit light of the second color, and the third phosphor 140 having a sixth light-emitting wavelength band that is converted by light emitted from the second light-emitting device to emit light of the third color.

Here, for example, the first color may be blue light and the second color may be green light. Additionally, the third color may be red light. In other words, the first light-emitting wavelength band may be a wavelength band corresponding to blue light. The second light-emitting wavelength band may be a wavelength band corresponding to green light. The third wavelength band may be a wavelength band corresponding to red light.

The first phosphor 140 and the third phosphor 140 may include the same phosphor material. Therefore, they will be described using the same reference numeral. However, the first phosphor 140 and the third phosphor 140 may also include phosphors of different materials that emit light of the same color. In this case, the emission peak of the spectrum of the first phosphor 140 and the emission peak of the spectrum of the second phosphor 140 may at least partially overlap.

Referring to FIG. 5, as an example, the second light-emitting device package 101 may be configured to include the package body 110 including the reflective cup 111 shape, the second light-emitting device 130 positioned within the package body 110, the first molding layer 170 covering the second light-emitting device 130 and positioned within the reflective cup 111 shape, and the second phosphor 150 and the third phosphor 140 positioned within the first molding layer 170.

Here, the first molding layer 170 may be formed using a resin material such as epoxy, silicone, or the like. The first phosphor 140 may be provided in a powder form and dispersed within the first molding layer 170.

Although not illustrated, the package body 110 includes circuit lines, and the first light-emitting device 120 may be mounted within the package body 110 and electrically connected to these circuit lines. The package body 110 may include pads that may be electrically connected to the outside. A detailed description of this configuration is omitted.

Meanwhile, the second light-emitting device package 101 may also be implemented in the form of a chip scale package (CSP) in which the second molding layer 171 in which the second phosphor 150 and the third phosphor 140 are dispersed, as described in FIG. 3, is coated to form a package.

The second light-emitting device used in the second light-emitting device package 101 may include a horizontal light-emitting device 130 as illustrated in FIG. 6 or a flip-chip type light-emitting device 130a as illustrated in FIG. 7.

Referring to FIG. 6, as an example used in the second light-emitting device package 101, the second light-emitting device 130 may be a light-emitting device that emits blue light. The second light-emitting device 130 may sequentially include a first conductive type (e.g., N-type) semiconductor layer 132, a light-emitting layer 134, and a second conductive type (e.g., P-type) semiconductor layer 133 on a substrate 131.

Here, the first conductive type semiconductor layer 132 may include, for example, an N-type nitride semiconductor (N-GaN) layer. The second conductive type semiconductor layer 133 may include, for example, a P-type nitride semiconductor (P-GaN) layer.

The first conductive type semiconductor layer 132 may be partially opened, and a first electrode 135 may be positioned on the opening. A second electrode 136 electrically connected to the second conductive semiconductor layer 133 may be positioned on the second conductive semiconductor layer 133.

Referring to FIG. 7, as another example used in the second light-emitting device package 101, the second light-emitting device 130a may be a light-emitting device that emits blue light. In this second light-emitting device 130a, a first conductive (e.g., N-type) semiconductor layer 132, a light-emitting layer 138, and a second conductive (e.g., P-type) semiconductor layer 137 may be sequentially positioned on a substrate 131.

A first electrode 139 electrically connected to the first conductive semiconductor layer 132 may be positioned on one side of the second conductive semiconductor layer 137. In this case, the first electrode 139 and the second conductive semiconductor layer 137 are insulated from each other, and the first electrode 139 may be connected to the first conductive semiconductor layer 132 by a structure such as a through hole.

The second electrode 136 electrically connected to the second conductive semiconductor layer 137 may be positioned on the other side of the second conductive semiconductor layer 137.

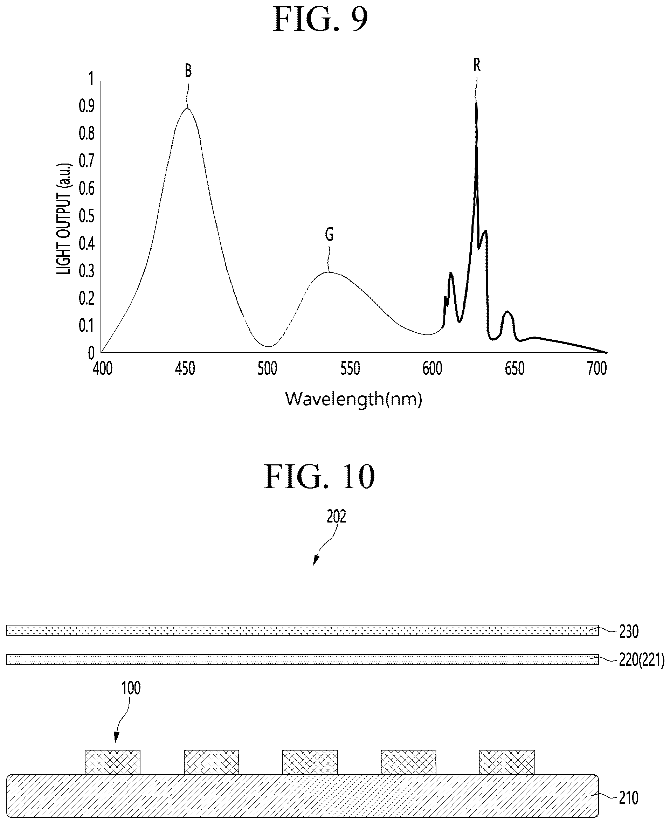

FIG. 8 is a diagram showing the emission spectrum of a first light-emitting device package applied to a planar lighting device according to a first embodiment of the present disclosure. FIG. 9 is a diagram showing the emission spectrum of a second light-emitting device package applied to a planar lighting device according to a first embodiment of the present disclosure.

As mentioned above, the planar lighting device 200 may include the first light-emitting device package 100 and the second light-emitting device package 101 having different color coordinate settings.

For example, the first light-emitting device package 100 and the second light-emitting device package 101 may be arranged adjacent to each other on the wiring board 210.

For example, the first light-emitting device package 100 and the second light-emitting device package 101 may be arranged alternately on the wiring board 210.

Referring to FIG. 8, the emission spectrum of the first light-emitting device package 100 is shown, in which light is emitted by the first light-emitting device 120 and the first phosphor 140 that emit light of the first color and light of the second color, respectively, in the first light-emitting layer 124 and the second light-emitting layer 125.

Referring to FIG. 9, the emission spectrum of the second light-emitting device package 101 in which light is emitted by the third light-emitting layer 134 and 138 emitting light of the first color, the second phosphor 150 emitting light of the second color, and the third phosphor 140 emitting light of the third color is shown.

Hereinafter, an example in which the first color is blue, the second color is green, and the third color is red will be described. However, the present disclosure is not limited thereto.

The first light-emitting wavelength band and the fourth light-emitting wavelength band described above include main peaks, and the wavelength bands of the main peaks within the first light-emitting wavelength band and the fourth light-emitting wavelength band may at least partially overlap with each other. For example, the first light-emitting wavelength band of light emitted from the first light-emitting device package 100 and the fourth light-emitting wavelength band of light emitted from the second light-emitting device package 101 may correspond to blue light.

The second light-emitting wavelength band and the fifth light-emitting wavelength band include main peaks, respectively, and the wavelength bands of the main peaks within the second light-emitting wavelength band and the fifth light-emitting wavelength band may at least partially overlap with each other. For example, the second light-emitting wavelength band of the light emitted from the first light-emitting device package 100 and the fifth light-emitting wavelength band of the light emitted from the second light-emitting device package 101 may correspond to blue light.

The third light-emitting wavelength band and the sixth light-emitting wavelength band described above include main peaks, respectively, and the wavelength bands of the main peaks within the third light-emitting wavelength band and the sixth light-emitting wavelength band may at least partially overlap with each other. For example, the third light-emitting wavelength band of the light emitted from the first light-emitting device package 100 and the sixth light-emitting wavelength band of the light emitted from the second light-emitting device package 101 may correspond to blue light.

Referring to FIGS. 8 and 9, it may be seen that the full width at half maximum (FWHM) of the first color light B and the second color light B emitted from the first light-emitting device package 100 are different from the full width at half maximum (FWHM) of the first color light B and the second color light B emitted from the second light-emitting device package 101, respectively.

For example, the full width at half maximum of the first color light B and the second color light B emitted from the first light-emitting device package 100 may be smaller than the full width at half maximum of the first color light B and the second color light B emitted from the second light-emitting device package 101, respectively.

Meanwhile, there may not be a significant difference in half-width between the third color light R emitted from the first light-emitting device package 100 and the third color light B emitted from the second light-emitting device package 101.

In this way, the half-width of the main peak of the emission spectrum emitted from the first light-emitting device package 100 may be relatively small. Accordingly, the color purity of the emission spectrum emitted from the first light-emitting device package 100 may be improved. Accordingly, the color purity of the white light emitted from the first light-emitting device package 100 may be improved. The color reproducibility of the planar lighting device 200 including the light-emitting device package 100 may be further improved.

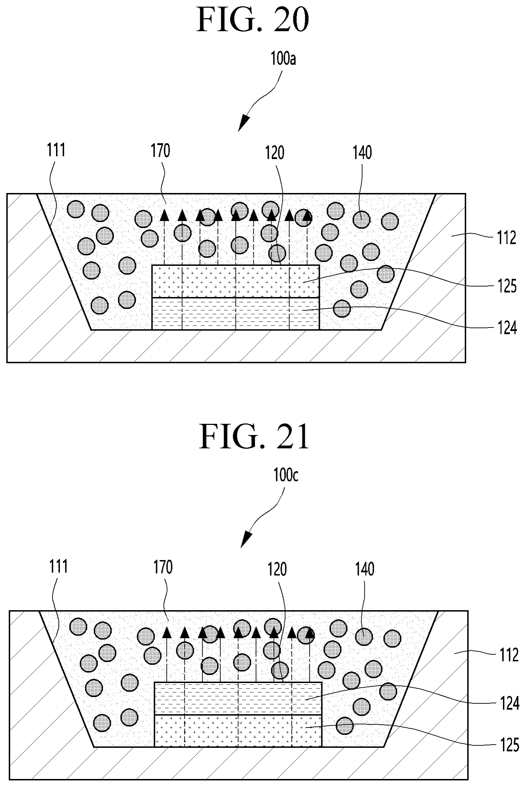

The emission peak of the spectrum of the first light-emitting wavelength band of light emitted from the first light-emitting device package 100 may be located within the emission peak of the spectrum of the fourth light-emitting wavelength band of light emitted from the second light-emitting device package 101 (see FIG. 21).

The intensity of the spectrum of the first light-emitting wavelength band of light emitted from the second light-emitting device package 101 may be less than the intensity of the spectrum of the fourth light-emitting wavelength band of light emitted from the second light-emitting device package 101 (see FIG. 21).

The emission peak of the spectrum of the second light-emitting wavelength band of light emitted from the first light-emitting device package 100 may be located within the emission peak of the spectrum of the fifth light-emitting wavelength band of light emitted from the second light-emitting device package 101 (see FIG. 21).

The intensity of the spectrum of the second light-emitting wavelength band of the light emitted from the second light-emitting device package 101 may be less than the intensity of the spectrum of the fifth light-emitting wavelength band of the light emitted from the second light-emitting device package 101 (see FIG. 21).

FIG. 10 is a conceptual diagram of a planar lighting device according to a second embodiment of the present disclosure.

Referring to FIG. 10, a planar lighting device 202 according to the second embodiment may include the wiring board 210, the light source including the plurality of first light-emitting device packages 100 arranged and positioned on the wiring board 210, and the light diffusion layer 220 (221) positioned on the light source.

Here, the light diffusion layer 220 (221) may be implemented as the light diffusion plate 220 or the light guide plate 221 depending on the shape of the backlight unit 200.

As an exemplary embodiment, the optical sheet 230 may be positioned on one side of the light diffusion layer 220 (221). For example, the light diffusion layer 220 (221) may be positioned between the wiring board 210 and the optical sheet 230. For example, the optical sheet 230 may include a plurality of layers having optical functions.

The first light emitting device package 100 may be arranged and provided on the wiring board 210. The plurality of light emitting device packages 100 may emit white light. The plurality of light-emitting device packages 100 may be positioned at regular intervals on the wiring board 210.

Although not illustrated separately, the wiring board 210 may include connection wiring electrically connected to the plurality of first light-emitting device packages 100. For example, at least some of the plurality of first light-emitting device packages 100 may be individually driven by the connection of such connection wiring. For example, the light sources may be driven simultaneously, or may be driven differently by each region. This type of driving in which the light sources are driven differently by each region may be referred to as local dimming driving. A detailed description thereof will be omitted herein.

Here, the first light-emitting device package 100 may include a stacked light-emitting device 120 (a first light-emitting device; see FIG. 2) having two light-emitting layers 124 and 125 (see FIG. 4). This first light-emitting device package 100 may emit white light having the first color coordinate by including the first light-emitting device 120 and the phosphor 140 (first phosphor; see FIG. 2) excited by light emitted from the first light-emitting device 120.

For example, the color reproducibility of the planar lighting device 200 may be improved by using the first light-emitting device package 100. The planar lighting device 200 may be implemented to be used in the display device 10 (see FIGS. 25 and 27) so that the display device 10 may express a target color coordinate.

The second embodiment may implement a planar lighting device 202 by using the plurality of first light-emitting device packages 100. In this way, the color purity of white light emitted from the first light-emitting device package 100 may be improved. The color reproducibility of the planar lighting device 202 including the light-emitting device package 100 may be further improved.

The same description as described in the first embodiment above may be applied to other parts not described. Therefore, redundant descriptions are omitted.

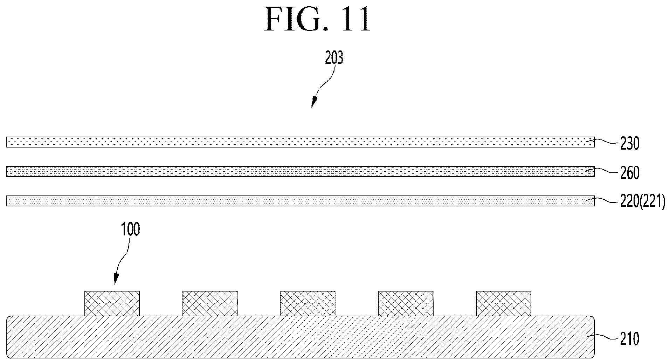

FIG. 11 is a conceptual diagram of a planar lighting device according to a third embodiment of the present disclosure.

Referring to FIG. 11, a planar lighting device 203 according to the third embodiment may include the wiring board 210, the light source including the plurality of first light-emitting device packages 100 arranged and positioned on the wiring board 210, and the light diffusion layer 220 (221) positioned on the light source.

As an exemplary embodiment, the optical sheet 230 may be positioned on one side of the light diffusion layer 220 (221). For example, the light diffusion layer 220 (221) may be positioned between the wiring board 210 and the optical sheet 230. For example, the optical sheet 230 may include a plurality of layers having optical functions.

A color-coordinated sheet 260 capable of controlling the color coordinates of light emitted from the first light-emitting device package 100 may be further provided on one side of the light diffusion layer 220 (221) or one side of the optical sheet 230. For example, the light emitted from the first light-emitting device package 100 may have a fixed color coordinate, and the fixed color coordinates may be controlled by the color-coordinated sheet 260.

For example, the color-coordinated sheet 260 may be positioned between the light diffusion layer 220 (221) and the optical sheet 230.

Parts not described above may be equally applied to the first or second embodiment. Therefore, redundant descriptions will be omitted.

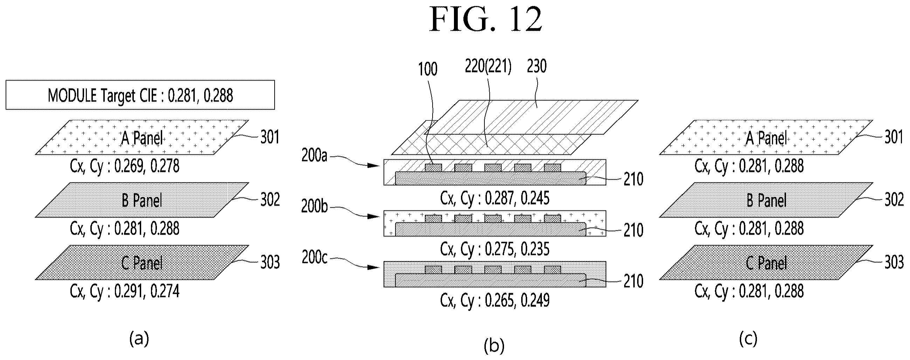

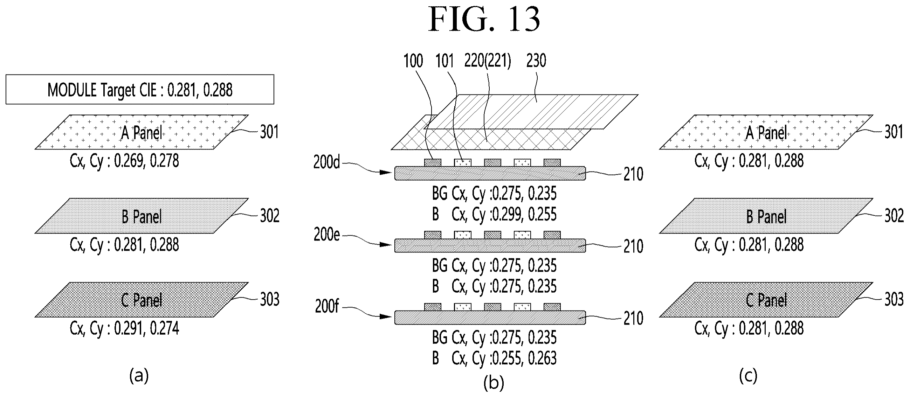

FIG. 12 is a schematic diagram illustrating a process of tuning a target color coordinate of the display device using the planar lighting device according to the second or third embodiment of the present disclosure. FIG. 13 is a schematic diagram illustrating a process of tuning a target color coordinate of the display device using the planar lighting device according to the first embodiment of the present disclosure.

As described above, the display device 10 or 11 (see FIGS. 25 and 27) may be manufactured using planar lighting devices 200, 202, or 203.

First, referring to FIG. 12, a process of tuning a target color coordinate of a display device using a planar lighting device according to the second or third embodiment will be described.

The display device 10 or 11 according to one embodiment may be configured to include a liquid crystal display panel 300 having the planar lighting device 202 or 203 that emits white light and a color conversion filter 310 (see FIGS. 25 and 27) positioned on the planar lighting device 202 or 203 and converting the white light of the planar lighting device 200. In this case, the planar lighting device 200 may include the light source including the plurality of first light-emitting device packages 100 that constitute a white light source. By implementing the planar lighting device 202 or 203 using the first light-emitting device package 100, the color reproducibility may be improved compared to the case of using a light-emitting device package that uses a blue light-emitting device and green and red phosphors.

Using the first light-emitting device package 100 as described above, the color coordinates of white light emitted from the planar lighting device 200 may be adjusted according to a target color coordinate. Meanwhile, the planar lighting device 200 may be implemented to be used in the display device 10 (see FIGS. 25 and 27) so that the display device 10 and 11 may express a target color coordinate.

First, referring to FIG. 12A, as an example, the target color coordinates target CIE of a display module in which the planar lighting device 200 and the display panel 300 are combined may be set. The display device 10 and 11 including the display module may be required to have a uniform color coordinate. For example, the target color coordinate (Cx, Cy) may be (0.281, 0.288) (Cx, Cy: 0.281, 0.288).

In this case, for example, there may be differences in the color coordinates of each panel. For example, referring to (A) of FIG. 12, the color coordinates of panel A 301 may be (Cx, Cy: 0.269, 0.278), the color coordinates of panel B 302 may be (Cx, Cy: 0.281, 0.288), and the color coordinates of panel C 303 may be (Cx, Cy: 0.291, 0.274), which may be different from each other.

As described above, excellent color reproducibility may be realized using the first light-emitting device package 100. In this case, the color coordinates of the light emitted from the first light-emitting device package 100 may be fixed according to the first light-emitting device 120. The first light-emitting device package 100 may have a constant light-emitting wavelength band since light of the first color (e.g., blue) and light of the second color (e.g., green) are emitted from the light-emitting layer of the first light-emitting device 120.

Therefore, in order to achieve a target color coordinate, the first light-emitting device packages 100 emitting light of different color coordinates may be used in combination with panels 301, 302 and 303 having different color coordinates.

Referring to FIG. 12B, different first light-emitting device packages 100 emitting light of which at least some have different color coordinates may be used. For example, in the first planar lighting device 200a, light emitted from the first light-emitting device package 100 may have a color coordinate of (Cx, Cy: 0.287, 0.245), in the second planar lighting device 200b, light emitted from the first light-emitting device package 100 may have a color coordinate of (Cx, Cy: 0.275, 0.235), and in the third planar lighting device 200c, light emitted from the first light-emitting device package 100 may have a color coordinate of (Cx, Cy: 0.265, 0.249).

In this way, different first light-emitting device packages 100, at least some of which emit light having different color coordinates, may be used to change tune corresponding to each panel 301, 302, or 303.

Accordingly, referring to (C) of FIG. 12, the same target color coordinates (Cx, Cy; 0.281, 0.288) may be implemented in each display device combining each panel 301, 302, or 303 and each planar lighting device 200a, 200b, or 200c.

In this way, the color reproducibility of the display device 10 using the planar lighting device backlight unit; 200 may be improved to the level of a self-luminous display device, while the target color coordinates of each of the display device 10 and 11 may be implemented. In addition, the brightness of the display device 10 may be maintained or improved.

Next, referring to FIG. 13, a process of tuning the target color coordinates of the display device using the planar lighting device according to the first embodiment will be described.

The display device 10 and 11 according to one embodiment may be configured to include the liquid crystal display panel 300 having the planar lighting device 200 that emits white light and the color conversion filter 310 (see FIGS. 25 and 27) positioned on the planar lighting device 200 and converting the white light of the planar lighting device 200. In this case, the planar lighting device 200 may include the light source including the plurality of first light-emitting device packages 100 and the plurality of second light-emitting device packages 101 that constitute a white light source.

As described above, the first light-emitting device package 100 may be configured to improve the color reproducibility of the planar lighting device 200 or the display device 10 and 11. Meanwhile, the second light-emitting device package 101 may be configured to improve the brightness of the planar lighting device 200 or the display device 10 and 11. In addition, the second light-emitting device package 101 may be configured to change the color coordinates of the planar lighting device 200 or the display device 10 and 11 according to a target color coordinate.

By using the first light-emitting device package 100 and the second light-emitting device package 101 having such different color coordinate settings, the color coordinates of white light emitted from the planar lighting device 200 may be adjusted according to the target color coordinates. Meanwhile, such a planar lighting device 200 may be implemented to be used in the display device 10 and 11 (see FIGS. 25 and 27) so that the display device 10 and 11 expresses the target color coordinates.

First, referring to (A) of FIG. 13, for example, a target color coordinate target CIE of the display module in which the planar lighting device 200 and the display panel 300 are combined may be set. The display device 10 and 11 including the display module may be required to have uniform color coordinates. For example, the target color coordinates (Cx, Cy) may be (0.281, 0.288) (Cx, Cy: 0.281, 0.288).

In this case, for example, a difference may occur in the color coordinates of each panel. For example, referring to (A) of FIG. 13, the color coordinates of the panel A 301 may be different from each other, such as (Cx, Cy: 0.269, 0.278), the color coordinates of the panel B 302 may be different from each other, such as (Cx, Cy: 0.281, 0.288), and the color coordinates of the panel C 303 may be different from each other, such as (Cx, Cy: 0.291, 0.274).

As described above, excellent color reproducibility may be realized using the first light-emitting device package 100, but the first light-emitting device package 100 may be fixed. The first light-emitting device package 100 may have a constant light-emitting wavelength band since light of the first color (e.g., blue) and light of the second color (e.g., green) are emitted from the light-emitting layer of the first light-emitting device 120.

Meanwhile, the second light-emitting device package 101 may be capable of changing tuning the color coordinates. Since the second color light emitted from the second light-emitting device package 101 is emitted by the second phosphor 150, the color coordinates of the light may be changed using the second light-emitting device package 101.

Referring to (B) of FIG. 13, the color coordinates of white light emitted from the first light-emitting device package 100 represented by BG may be fixed at (Cx, Cy: 0.275, 0.235). However, the light emitted from the second light-emitting device package 101 represented by B may have different values in each panel in order to implement the target color coordinates. For example, in the first planar lighting device 200d, the light emitted from the second light-emitting device package 101 may have a color coordinate of (Cx, Cy: 0.299, 0.255), in the second planar lighting device 200e, the light emitted from the second light-emitting device package 101 may have a color coordinate of (Cx, Cy: 0.275, 0.235), and in the third planar lighting device 200f, the light emitted from the second light-emitting device package 101 may have a color coordinate of (Cx, Cy: 0.255, 0.265).

In this way, the color coordinate of the light emitted from the second light-emitting device package 101 may be changed tuned corresponding to each panel 301, 302, and 303. The light emitted from the light emitting device 120 and 130 has a fixed color coordinate, but the phosphor 140 and 150 that emits light converted by being excited by the light emitted from the light emitting device 120 and 130 may be changed according to the content, material, and the like.

For example, the second type of the second light emitting device package 101 The content of at least one of the light body 150 or the third phosphor 140 may be adjusted according to the transmission spectrum of the color conversion filter 310 of the display device 10 and 11. For example, the second phosphor 150 may have a first content so as to have a target color coordinate value of the liquid crystal display panel 300. For example, the third phosphor 140 may have a second content so as to have a target color coordinate value of the liquid crystal display panel 300.

Accordingly, referring to (C) of FIG. 13, the same target color coordinate (Cx, Cy; 0.281, 0.288) may be implemented in each display device that combines each panel 301, 302 and 303 and each planar lighting device 200d, 200e and 200f.

In this way, the color reproducibility of the display device 10 and 11 using the planar lighting device (backlight unit) 200 may be improved to the level of a self-luminous display device, while the target color coordinates of each display device 10 and 11 may be implemented. In addition, the brightness of the display device 10 and 11 may be maintained or improved.

Meanwhile, since the shift in the color coordinate according to the current of the second light-emitting device package 101 tends to be smaller than the shift in the color coordinate according to the current of the first light-emitting device package 100, the color change rate according to the driving current may be reduced by configuring the first light-emitting device package 100 and the second light-emitting device package 101 together in the planar lighting device 200.

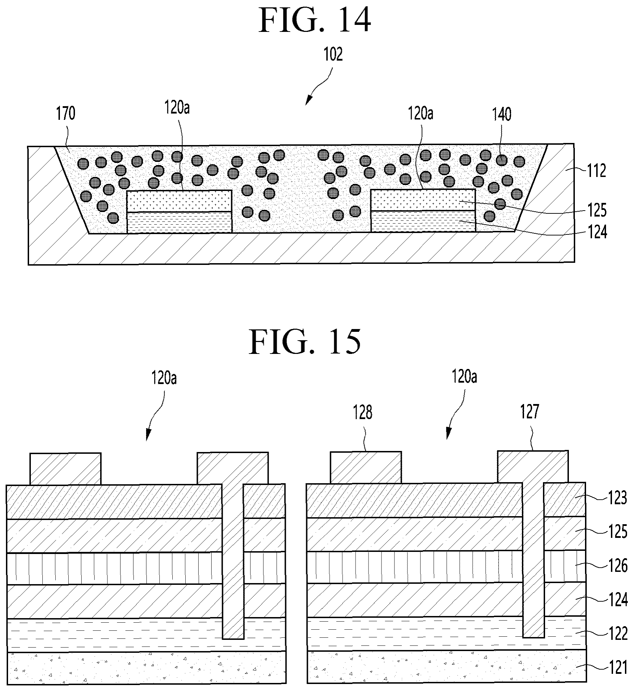

FIGS. 14 to 19 are cross-sectional schematic diagrams illustrating another embodiments of the first light-emitting device package applied to the planar lighting device according to the embodiments of the present disclosure. FIGS. 14, 16, and 18 illustrate other embodiments of the first light-emitting device package, and FIGS. 15, 17, and 19 illustrate implementation examples of the first light-emitting device used in these first light-emitting device packages.

Referring to FIG. 14, an example of a first light-emitting device package 102 including a plurality of light-emitting devices 120a (first light-emitting devices) is illustrated. For example, the first light-emitting device package 102 may include two adjacent light-emitting devices 120. These two light-emitting devices 120a may be referred to as the first-1 light-emitting device and the first-2 light-emitting device, respectively.

As described above, the first light-emitting device 120a may include the first light-emitting layer 124 that is provided in a stacked manner and has the first light-emitting wavelength band that emits light of the first color, and the second light-emitting layer 125 that has the second light-emitting wavelength band that emits light of the second color. Here, the positions of the first light-emitting layer 124 and the second light-emitting layer 125 may be interchanged.

Referring to FIG. 15, two light-emitting devices 120a having the same position of the first light-emitting layer 124 and the second light-emitting layer 125 may be positioned adjacent to each other. In the light-emitting device 120a, the second light-emitting layer 125 may be positioned on the first light-emitting layer 124.

This first light-emitting device package 102 may be configured to include the package body 110 including the reflective cup 111 shape, two first light-emitting devices 120a positioned adjacent to each other within the package body 110, the first molding layer 170 covering the first light-emitting devices 120a and positioned within the reflective cup shape 111, and a first phosphor 140 positioned within the first molding layer 170.

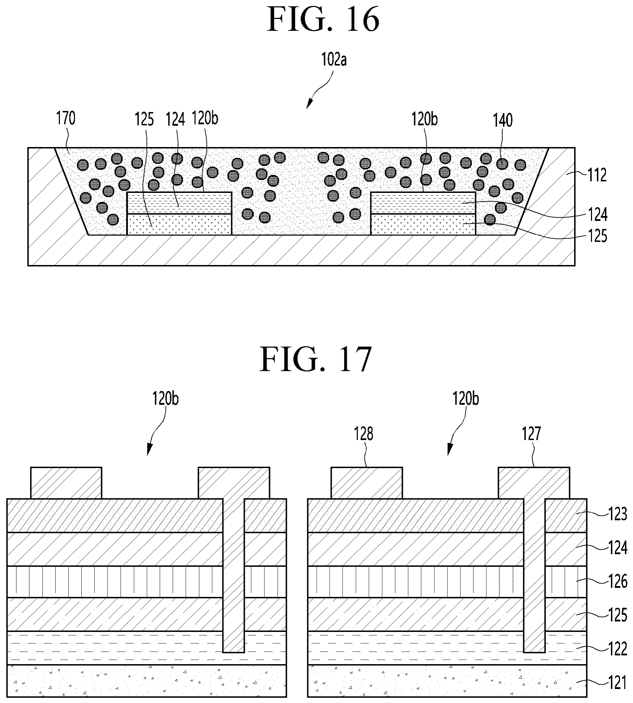

Referring to FIG. 16, an example of a first light-emitting device package 102a including a plurality of light-emitting devices 120b (first light-emitting devices) is shown.

Referring to FIG. 17, two light-emitting devices 120b having the same positions of the first light-emitting layer 124 and the second light-emitting layer 125 may be positioned adjacent to each other. The light-emitting device 120b may have the first light-emitting layer 124 positioned on the second light-emitting layer 125.

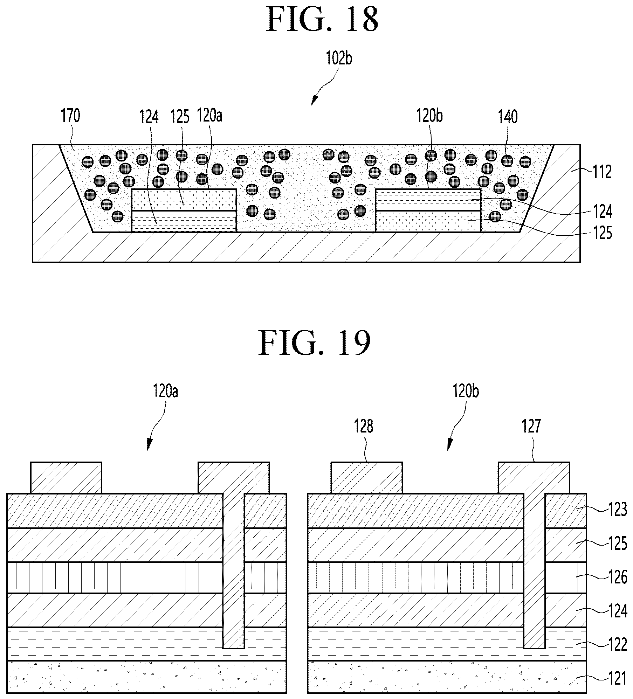

Referring to FIGS. 18 and 19, two light-emitting devices 120a and 120b having different positions of the first light-emitting layer 124 and the second light-emitting layer 125 may be positioned adjacent to each other in the first light-emitting device package 102b.

For example, the light-emitting device 120a having the second light-emitting layer 125 positioned on the first light-emitting layer 124 and the light-emitting device 120b having the first light-emitting layer 124 positioned on the second light-emitting layer 125 may be positioned adjacent to each other in the first light-emitting device package 102b.

FIGS. 20 and 21 are diagrams for describing differences according to the stacking order of the first light-emitting device package applied to the planar lighting device according to embodiments of the present disclosure.

FIG. 20 shows an example of the light-emitting device package 100a to which the light-emitting device 120 is applied, in which the second light-emitting layer 125 is positioned on the first light-emitting layer 124, and FIG. 21 shows an example of the light-emitting device package 100c to which the light-emitting device 120 is applied, in which the first light-emitting layer 124 is positioned on the second light-emitting layer 125.

Among these light-emitting device packages 100a and 100c, when the first light-emitting layer 125 emitting light of the first color (e.g., blue) is positioned on the upper side, as in the example of FIG. 20, light corresponding to the second color (e.g., green) may have a relatively low light quantity because it passes through the first light-emitting layer 125. Accordingly, the intensity of the green light may be weakened, resulting in a relatively low color reproducibility. On the other hand, since blue light is directly emitted and has relatively high energy that may excite the first phosphor 140, high brightness may be achieved.

Among these light-emitting device packages 100a and 100c, when the second light-emitting layer 124 emitting light of a second color e.g., green is positioned on the upper side, as in the example of FIG. 21, light corresponding to the first color (e.g., blue) may have relatively weaker energy to excite the first phosphor 140 because it passes through the second light-emitting layer 124. On the other hand, green light may be directly emitted, thereby increasing color reproducibility.

In the planar lighting device 200 according to embodiments of the present disclosure, light-emitting device packages 100a and 100c having such different arrangements of light-emitting layers 124 and 125 may be selectively used.

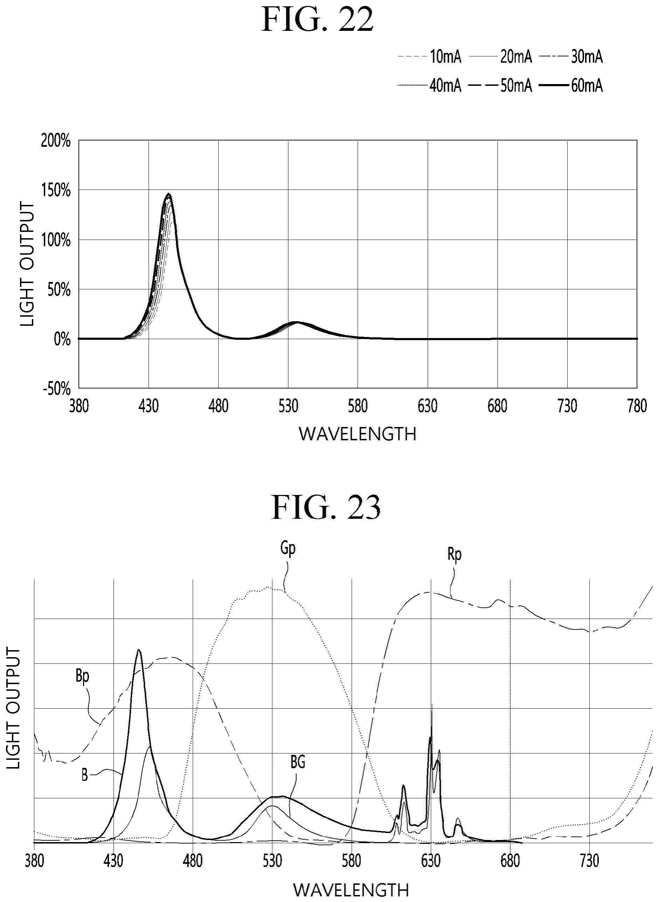

FIG. 22 is a diagram illustrating a wavelength change according to a driving current of the first light-emitting device package applied to the planar lighting device according to embodiments of the present disclosure.

As mentioned above, when the planar lighting device 200 is used in the display device 10 and 11, the wavelength of light in some wavelength bands may shift due to the current that varies depending on the screen.

For example, the wavelength shift according to the current of the first light-emitting device 120 in the first light-emitting device package 100 may be greater than that of the second light-emitting device 130 applied to the second light-emitting device package 101.

As such, the shift in color coordinates according to the current of the second light-emitting device package 101 tends to be smaller than the shift in color coordinates according to the current of the first light-emitting device package 100. Therefore, by configuring the planar lighting device 200 with the first light-emitting device package 100 and the second light-emitting device package 101, the color change rate according to the driving current may be reduced.

FIG. 23 is a diagram illustrating the emission spectrum of the display device according to the embodiments of the present disclosure.

FIG. 23 comprehensively shows the spectrum of light emitted from the display device 10 and 11. In FIG. 23, the upper portion shows the transmission region of the panel 300. For example, the transmission wavelength band by the color conversion filter (color filter 310) of the panel 300 is shown. Bp represents the transmission wavelength band by the blue filter, Gp represents the transmission wavelength band by the green filter, and Rp represents the transmission wavelength band by the red filter.

Meanwhile, in FIG. 23, the spectrum indicated by BG represents the emission spectrum of the first light-emitting device package 100, and the spectrum indicated by B represents the emission spectrum of the second light-emitting device package 101.

As is well known, all colors may be expressed using the three primary colors of red R, green G, and blue B. When red R, green G, and blue B light are mixed, white light is created. When this light source passes through the color conversion filter (color filter; 310), each color may be distinguished.

Therefore, when a color filter with a high extreme value for the wavelength corresponding to each color meets an input light source, the output light may be a value obtained by multiplying the area corresponding to the wavelength of the color filter by the input light source.

In this case, the output light is clearly distinguished by color, and the higher the extreme value, the more accurately the colors are expressed without mixing. To this end, it is desirable for the color filter to clearly distinguish and pass light without mixing with other colors, and it is advantageous to use a light source with clearly distinguished output wavelengths of red R, green G, and blue B.

Therefore, as described above, by using the first light-emitting device package 100 in which the wavelengths of red R, green G, and blue B light are relatively clearly distinguished, high-output, high-purity colors matched by the color filter may be realized.

Meanwhile, by using the second light-emitting device package 101 in combination with a relatively high light intensity, color coordinate tuning is possible, and wavelength shift according to current is relatively small, the target color coordinates of each display device 10 and 11 may be easily realized.

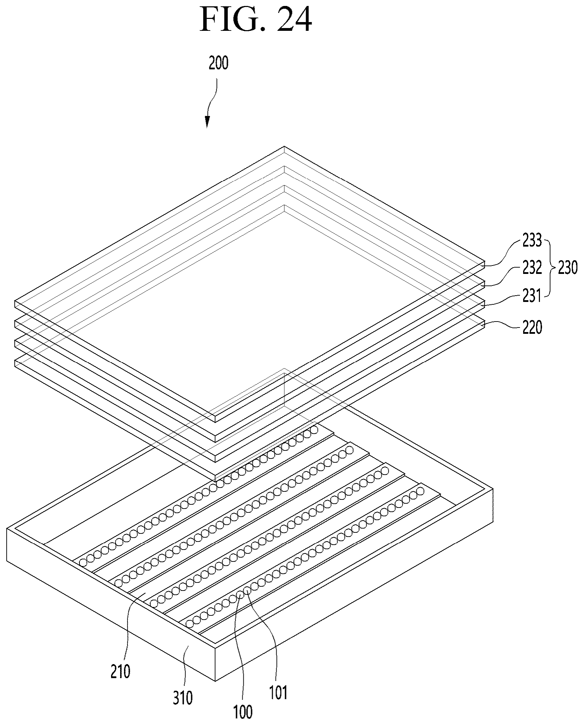

FIGS. 24 and 25 are diagrams illustrating a display device according to a first embodiment of the present disclosure.

Referring to FIGS. 24 and 25, an example of the display device 10 including the direct-type planar lighting device 200 that uses the first light-emitting device package 100 and the second light-emitting device package 101 according to the first embodiment described above as a light source is shown. An example of the display device 10 including the planar lighting device 200 may be the liquid crystal display device 10.

The liquid crystal display device 10 may have the planar lighting device 200 positioned on a lower cover 340. This planar lighting device 200 may include the first light-emitting device package 100 and the second light-emitting device package 101 according to embodiments of the present disclosure. FIGS. 24 and 25 exemplarily show the planar lighting device 200 that uses the first light-emitting device package 100 and the second light-emitting device package 101 according to the first embodiment as a light source. Meanwhile, the planar lighting device 200 may be implemented using the first light-emitting device package 100 as a light source.

The light diffuser plate 220 may be positioned on the light source. The optical sheet 230 may be provided on the light diffuser plate 220. Here, the optical sheet 230 may include a plurality of functional films 231, 232, and 233.

A reflective sheet 250 may be positioned between the planar lighting device 200 and the lower cover 340.

The liquid crystal display panel 300 may be positioned on the planar lighting device 200. Additionally, the liquid crystal display panel 300 may be supported by a mold frame 330. An upper cover 320 may be positioned on the mold frame 330.

Although not separately indicated, the liquid crystal display panel 300 may include a liquid crystal layer, a color conversion filter color filter; 310, a polarizing sheet, and the like.

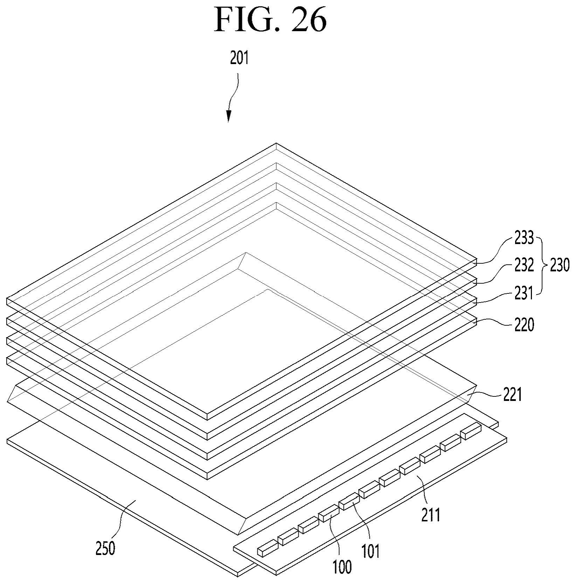

FIGS. 26 and 27 are diagrams illustrating a display device according to a second embodiment of the present disclosure.

Referring to FIGS. 26 and 27, an example of the display device 11 including an edge-type planar lighting device 201 that uses the first light-emitting device package 100 and the second light-emitting device package 101 according to the first embodiment described above as a light source is illustrated. An example of the display device 11 including the planar lighting device 201 may be the liquid crystal display device 10.

The edge-type planar lighting device 201 may diffuse light using the light guide plate 221. The optical sheet 230 may be provided on the light guide plate 221. Here, the optical sheet 230 may include the plurality of functional films 231, 232, and 233.

The liquid crystal display device 11 may have the planar lighting device 201 positioned on the lower cover 340. The planar lighting device 201 may include the first light-emitting device package 100 and the second light-emitting device package 101 according to embodiments of the present disclosure. FIGS. 26 and 27 exemplarily illustrate a planar lighting device 201 that uses the first light-emitting device package 100 and the second light-emitting device package 101 according to the first embodiment as a light source. Meanwhile, a planar lighting device 201 may be implemented using the first light-emitting device package 100 as a light source.

The reflective sheet 250 may be positioned between the planar lighting device 201 and the lower cover 340.

The liquid crystal display panel 300 may be positioned on the planar lighting device 201. In addition, the liquid crystal display panel 300 may be supported by the mold frame 330. The upper cover 320 may be positioned on the mold frame 330.

A heat bar 270 may be positioned on one side of the mold frame 330, and a wiring board 211 may be positioned on the heat bar 270. Light may be irradiated from the light source toward the light guide plate 221.

Although not specifically indicated, the liquid crystal display panel 300 may include a liquid crystal layer, a color conversion filter color filter; 310, a polarizing sheet, and the like.

The features, structures, effects, and the like described in the embodiments above are included in at least one embodiment of the present disclosure, and are not necessarily limited to merely one embodiment. Furthermore, the features, structures, effects, and the like exemplified in each embodiment may be combined or modified to implement other embodiments by those skilled in the art to which the embodiments pertain. Therefore, it should be construed that such combinations and modifications fall within the scope of the present disclosure.

Furthermore, while the embodiments have been described above, these are merely examples and do not limit the present disclosure. Those skilled in the art will appreciate that various modifications and applications not exemplified above are possible without departing from the essential characteristics of the embodiments. For example, each component specifically illustrated in the embodiments may be modified and implemented. And the differences related to these modifications and applications should be construed as being included within the scope of the present disclosure as defined in the appended claims.

## Claims

1. A planar lighting device (200, 201) comprising:
a wiring board (210);
a light source including a plurality of first light-emitting device packages (100) and a plurality of second light-emitting device packages (101) disposed on the wiring board (210); and
a light diffusion layer (220) disposed on the light source,
wherein the first light-emitting device package (100) includes:
a first light-emitting device (120) including a first light-emitting layer (124) having a first light-emitting wavelength band that emits light of a first color and a second light-emitting layer (125) having a second light-emitting wavelength band that emits light of a second color; and
a first phosphor (140) having a third light-emitting wavelength band converted by light emitted from the first light-emitting device (120) to emit light of a third color, and
wherein the second light-emitting device package (101) includes:
a second light-emitting device (130) including a third light-emitting layer (134, 138) having a fourth light-emitting wavelength band that emits light of the first color;
a second phosphor (150) having a fifth light-emitting wavelength band converted by light emitted from the second light-emitting device (130) to emit light of the second color; and
a third phosphor (140) having a sixth light-emitting wavelength band converted by light emitted from the second light-emitting device (130) to emit light of the third color.

2. The planar lighting device (200, 201) of claim 1, wherein a half-width of spectrum of the first light-emitting wavelength band is narrower than a half-width of spectrum of the fourth light-emitting wavelength band.

3. The planar lighting device (200, 201) of claim 1, wherein an intensity of spectrum of the first light-emitting wavelength band is smaller than an intensity of spectrum of the fourth light-emitting wavelength band.

4. The planar lighting device (200, 201) of claim 1, wherein a half-width of spectrum of the fifth light-emitting wavelength band is narrower than a half-width of spectrum of the second light-emitting wavelength band.

5. The planar lighting device (200, 201) of claim 1, wherein an intensity of spectrum of the fifth light-emitting wavelength band is smaller than an intensity of spectrum of the second light-emitting wavelength band.

6. The planar lighting device (200, 201) of claim 1, wherein the first light-emitting device package (100) and the second light-emitting device package (101) have different color coordinate settings.

7. The planar lighting device (200, 201) of claim 1, wherein the first light-emitting device package (100) and the second light-emitting device package (101) are disposed adjacent to each other.

8. The planar lighting device (200, 201) of claim 1, wherein a shift in a color coordinate of the second light-emitting device package (101) according to current is smaller than a shift in a color coordinate of the first light-emitting device package (100) according to current.

9. The planar lighting device (200, 201) of claim 1, wherein the first light-emitting device package (100) includes a first-1 light-emitting device and a first-2 light-emitting device that are adjacent to each other.

10. The planar lighting device (200, 201) of claim 9, wherein the first-1 light-emitting device and the first-2 light-emitting device have different stacking orders of the first light-emitting layer (124) and the second light-emitting layer (125).

11. The planar lighting device (200, 201) of claim 1, further comprising:
a liquid crystal display panel (300) having a color conversion filter (310) for converting the white light of the planar lighting device (200, 201).

12. The planar lighting device (200, 201) of claim 11, wherein a content of at least one of the second phosphor (150) or the third phosphor (140) of the second light-emitting device package (101) is adjusted according to a transmission spectrum of the color conversion filter (310).

13. The planar lighting device (200, 201) of claim 11, wherein the second phosphor (150) has a first content so as to have a target color coordinate value of the liquid crystal display panel (300).

14. The planar lighting device (200, 201) of claim 11, wherein the third phosphor has a second content so as to have a target color coordinate value of the liquid crystal display panel (300).

15. The planar lighting device (200, 201) of claim 11, wherein the first light-emitting device package (100) and the second light-emitting device package (101) are disposed adjacent to each other.
